# EUROPEAN PATENT APPLICATION

(11) **EP 2 639 831 A2**
(43) Date of publication of application: **18.09.2013**
(21) Application number: 13159293.3
(22) Date of filing: 14.03.2013
(51) Int. Cl.: H01L 25/075, H01L 33/48

(54) **Light emitting diode package**

(30) Priority: 16.03.2012 TW 101109145
(71) Applicant: Lextar Electronics Corp., 30075 Hsinchu (TW)
(72) Inventor: Yu, Zong-Han, 206 Keelung City (TW); Chen, Chih-Ming, Hsinchu 30075 (TW)
(74) Representative: Granleese, Rhian Jane

(57) **Abstract**

A LED (light emitting diode) package includes a substrate (100), at least one LED (200), at least one wire-bonding structure (300) and at least one protecting structure(400). The substrate (100) includes a die-bonding area (110) and a wire-bonding area (10). The wire-bonding area (120) surrounds the die-bonding area (110). The LED (200) is disposed on the die-bonding area (110). The wire-bonding structure (300) is disposed on the wire-bonding area (120), and includes a lateral wall (302). The lateral wall (302) stands between the wire-bonding area (120) and the die-bonding area (110). The protecting structure (400) covers the lateral wall (302) and part of surface of the wire-bonding structure (300).

## Description

### BACKGROUND

### Technical Field

Embodiments of the invention relate to a package. More particularly, embodiments of the invention relate to a LED (light emitting diode) package.

### Description of Related Art

In a conventional LED (light emitting diode) package, a LED chip and a wire layer are typically disposed on dielectric layers with equal heights. However, since the LED chip inevitably generates thermal power while emitting light and the heat dissipation capability of the dielectric layer is poor, generally an overheat problem of the LED chip will be caused. Therefore, related manufactures have developed a Chip on Board (referred to as COB for short hereafter) technique.

The so-called COB LED package refers to that the dielectric layer underneath the LED chip is removed, so that the LED chip directly adheres on a heat-conducting substrate for reducing a thermal resistance, thereby solving the overheat problem of the LED chip.

However, after the dielectric layer underneath the LED chip is removed, the dielectric layer underneath the wire layer will be exposed and subjected to the light irradiation of the LED chip. After the dielectric layer has been used for a long period of time, the light irradiation received by the exposed dielectric layer and the radiant heat caused thereby will facilitate the aging of the dielectric layer. Furthermore, since a general dielectric layer is made of a white material for reflecting the light and thus increasing the entire light emission rate of the LED package, if the dielectric layer is aged, the color thereof will gradually darken to yellow, and thus the light emission rate is reduced, shortening the lifetime of the LED package.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

Embodiments of the invention provide a COB LED (light emitting diode) package, under which an exposed dielectric layer adjacent to the LED chip can be avoided from aging, so as to increase the lifetime of the LED package.

According to an embodiment of the invention, a LED package includes a substrate, at least one LED, at least one wire-bonding structure and at least one protecting structure. The substrate has a die-bonding area and a wire-bonding area. The wire-bonding area surrounds the die-bonding area. The LED is disposed on the die-bonding area. The wire-bonding structure is disposed on the wire-bonding area and includes a lateral wall. The lateral wall stands between the wire-bonding area and the die-bonding area. The protecting structure covers the lateral wall and part of surface of the wire-bonding structure.

The aforesaid embodiment of the invention can use a protecting structure to cover the lateral wall and part of surface of the wire-bonding structure, so that even when the dielectric layer in the wire-bonding structure is exposed at the surface and/or the lateral wall, the protecting structure still covers the dielectric layer to avoid the dielectric layer from the light irradiation of the LED, thereby preventing the dielectric layer from aging.

It is to be understood that both the foregoing general description and the following detailed description are by examples, and are intended to provide further explanation of the invention as claimed.

### BRIEF DESCRIPTION OF THE DRAWINGS

In order to make the foregoing as well as other aspects, features, advantages, and embodiments of the invention more apparent, the accompanying drawings are described as follows:
Fig. 1 is a cross-sectional view of a LED package according to an embodiment of the invention;
Fig. 2 is a cross-sectional view of the wire-bonding structure and the protecting structure shown in Fig. 1;
Fig. 3 is a cross-sectional view of the wire-bonding structure and the protecting structure according to another embodiment of the invention;
Fig. 4 is a cross-sectional view of the wire-bonding structure and the protecting structure according to a further embodiment of the invention;
Fig. 5 is a cross-sectional view of the wire-bonding structure and the protecting structure according to still a further embodiment of the invention;
Fig. 6 is a cross-sectional view of the substrate according to an embodiment of the invention; and
Fig. 7 is a cross-sectional view of a LED package according to another embodiment of the invention.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

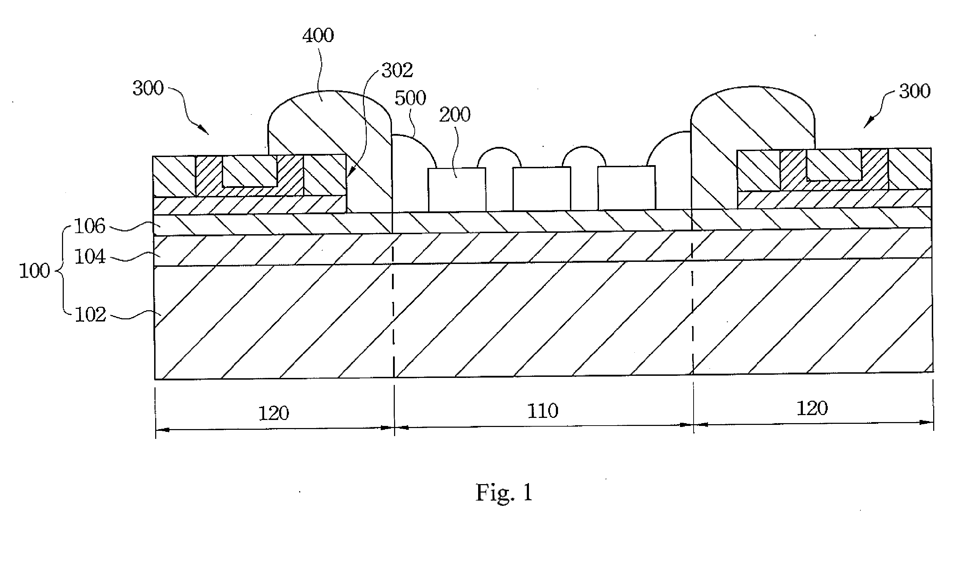

Fig. 1 is a cross-sectional view of a LED package according to an embodiment of the invention. As shown in the figure, the LED package of the embodiment includes a substrate 100, at least one LED 200, at least one wire-bonding structure 300 and at least one protecting structure 400. The substrate 100 has a die-bonding area 110 and a wire-bonding area 120. The wire-bonding area 120 surrounds the die-bonding area 110. The LED 200 is disposed on the die-bonding area 110. The wire-bonding structure 300 is disposed on the wire-bonding area 120 and includes a lateral wall 302. The lateral wall 302 stands between the wire-bonding area 120 and the die-bonding area 110. The protecting structure 400 covers the lateral wall 302 and part of surface of the wire-bonding structure 300.

For example, the lateral wall 302 of the wire-bonding structure 300 is substantially perpendicular between the wire-bonding area 120 and the die-bonding area 110, and the protecting structure 400 covers the lateral wall 302 of the wire-bonding structure 300 to avoid the lateral wall 302 from being directly irradiated by the light emitted from the LED 200, so that even when the wire-bonding structure 300 includes a dielectric layer and the dielectric layer is exposed on the surface and/or lateral wall 302 of the wire-bonding structure 300, the dielectric layer still can be protected as being covered by the protecting structure 400, achieving an effect avoiding aging.

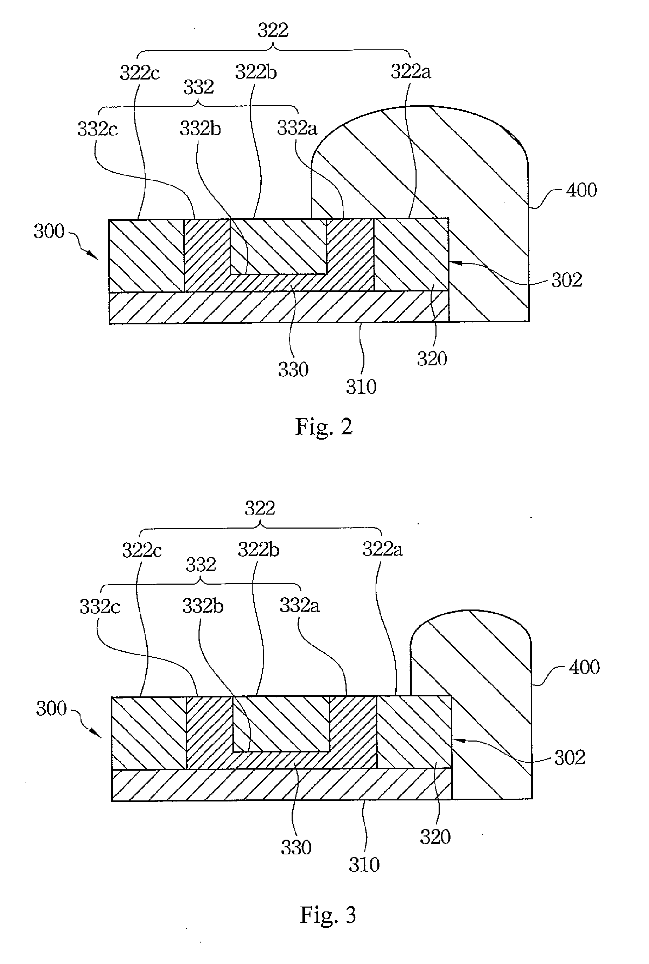

Fig. 2 illustrates a cross-sectional view of the wire-bonding structure 300 and the protecting structure 400 shown in Fig. 1. As shown in the figure, the wire-bonding structure 300 of the embodiment may include an insulation layer 310, a first dielectric layer 320 and a wire layer 330. The first dielectric layer 320 is disposed on the insulation layer 310. The wire layer 330 is disposed in a predetermined area of the first dielectric layer 320.

In some embodiments, part of the first dielectric layer 320 is exposed on the lateral wall 302 of the wire-bonding structure 300 and is covered by the protecting structure 400. For example, the lateral wall 302 of the wire-bonding structure 300 may be formed by the edge of the first dielectric layer 320. Since the protecting structure 400 can cover the lateral wall 302, the edge of the first dielectric layer 320 can be further covered to avoid the edge of the first dielectric layer 320 from being directly exposed to the light emitted by the LED 200 (referring to Fig. 1), so as to avoid the first dielectric layer 320 from facilitated aging as being subjected to the light irradiation and the radiation heat.

In some embodiments, the wire layer 330 has an upper surface 332; the first dielectric layer 320 has an upper surface 322; and the protecting structure 400 covers part of the upper surface 332 of the wire layer 330 and part of the upper surface 322 of the first dielectric layer 320.

In particular, the upper surface 332 of the wire layer 330 may include a first upper surface 332a, a second upper surface 332b and a third upper surface 332c; and the upper surface 322 of the first dielectric layer 320 may include a first upper surface 322a, a second upper surface 322b and a third upper surface 322c. As shown in Fig. 2, the first upper surface 322a of the first dielectric layer 320 and the first upper surface 332a of the wire layer 330 may be entirely covered by the protecting structure 400.

In some embodiments, the upper surface 332 of the wire layer 330 is partially exposed, so that the exposed wire layer 330 can be connected to the LED 200 through a conducting wire 500 (referring to Fig. 1). The second upper surface 332b of the wire layer 330 is disposed between the first upper surface 332a and the third upper surface 332c, and the height of the second upper surface 332b is lower than those of the first upper surface 332a and the third upper surface 332c. The first upper surface 332a and the third upper surface 332c are exposed on the wire-bonding structure 300, so as to electrically connect to the conducting wire 500.

In some embodiments, the first upper surface 322a, a second upper surface 322b and a third upper surface 322c of the first dielectric layer 320 are separated by the first upper surface 332a and the third upper surface 332c of the wire layer 330.

In some embodiments, first the insulation layer 310 is deposited on the wire-bonding area 120 of the substrate 100 (referring to Fig. 1). Then the wire layer 330 is deposited on the insulation layer 310 and is etched, so that the height of the second upper surface 332b of the wire layer 330 is lower than those of the first upper surface 332a and the third upper surface 332c. Subsequently the first dielectric layer 320 is deposited on the insulation layer 310 to form the wire-bonding structure 300. The LED 200 is wire-bonded to the first upper surface 332a of the wire layer 330. Afterwards the protecting structure 400 may be formed on the wire-bonding structure 300, and at least covers the lateral wall 302 of the wire-bonding structure 300.

Fig. 3 is a cross-sectional view of the wire-bonding structure 300 and the protecting structure 400 according to another embodiment of the invention. This embodiment is substantially similar to the embodiment of Fig. 2, and the main difference is that the first upper surface 322a of the first dielectric layer 320 according to this embodiment is only partially covered by the protecting structure 400 while the first upper surface 332a of the wire layer 330 is not covered by the protecting structure 400.

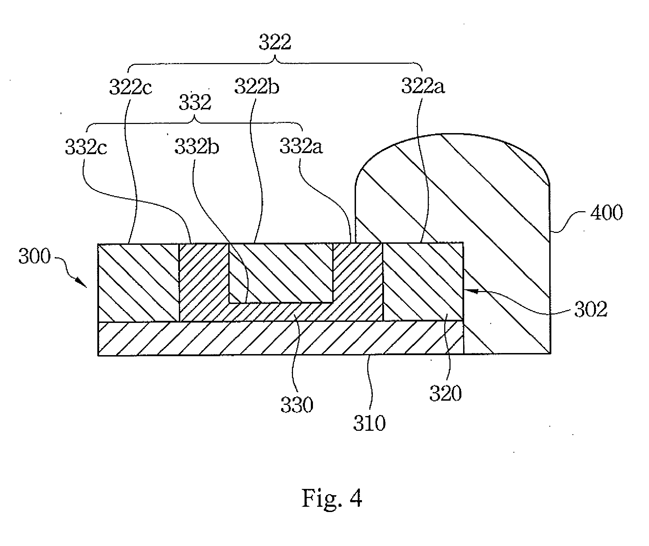

Fig. 4 is a cross-sectional view of the wire-bonding structure 300 and the protecting structure 400 according to a further embodiment of the invention. This embodiment is substantially similar to the embodiment of Fig. 2, and the main difference is that the first upper surface 332a of the wire layer 330 is only partially covered by the protecting structure 400.

In some embodiments, part of the conducting wire 500 (See Fig. 1) may also be covered by the protecting structure 400. In other words, the conducting wire 500 may be electrically connected to the wire layer 330 and then electrically connected to the LED 200 after passing through the protecting structure 400.

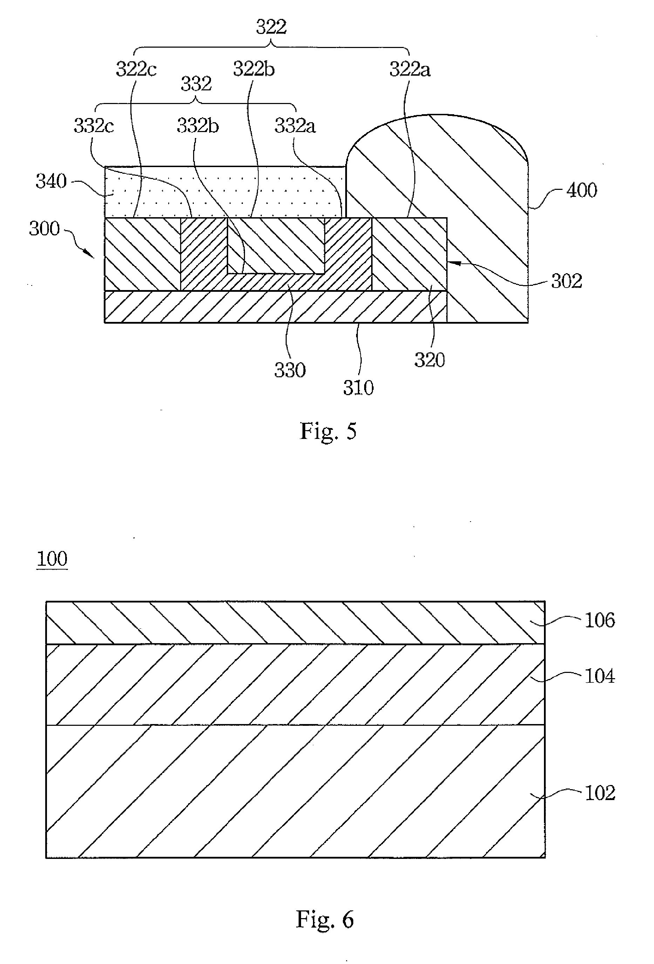

Fig. 5 is a cross-sectional view of the wire-bonding structure 300 and the protecting structure 400 according to still a further embodiment of the invention. This embodiment is substantially similar to the embodiment of Fig. 4, and the main difference is that the LED package according to this embodiment may further include a second dielectric layer 340. The second dielectric layer 340 is disposed on the rest of the upper surface 322 of the first dielectric layer 320 that is not covered by the protecting structure 400 and on the rest of the upper surface 332 of the wire layer 330 that is not covered by the protecting structure 400.

In particular, the first upper surface 322a of the first dielectric layer 320 is covered by the protecting structure 400, and the rest exposed second upper surface 322b and third upper surface 322c of the first dielectric layer 320 are covered by the second dielectric layer 340. Part of the first upper surface 332a of the wire layer 330 is covered by the protecting structure 400, and the rest exposed first upper surface 332a and third upper surface 332c of the wire layer 330 are covered by the second dielectric layer 340. In some embodiments, the second dielectric layer 340 is made of a dielectric material.

In some embodiments, after the first dielectric layer 320 is deposited, the second dielectric layer 340 is deposited on the second upper surface 322b and third upper surface 322c of the first dielectric layer 320 and on part of the first upper surface 332a and the third upper surface 332c of the wire layer 330. Thereafter, the protecting structure 400 may be formed on the rest first upper surface 322a of the first dielectric layer 320 and on the rest part of the first upper surface 332a of the wire layer 330.

In some embodiments, the protecting structure 400 is made of a reflective resin material to avoid the light emitted by the LED 200 from irradiating to the first dielectric layer 320 as passing through the protecting structure 400.

For example, the reflective resin material applied in the protecting structure 400 may be, but is not limited to be, a silicon mixture containing a metal oxide or an epoxy mixture containing a metal oxide. The aforesaid metal oxide may have a light-tight property, and may be, but is not limited to be, a titanium oxide or aluminium oxide. In some embodiments, the protecting structure 400 may be a columnar body with a circular-arch top surface.

Fig. 6 is a cross-sectional view of the substrate 100 according to an embodiment of the invention. As shown in the figure, the substrate 100 of this embodiment includes a heat-conducting layer 102 and a reflecting layer 104. The heat-conducting layer 102 is used for facilitating the heat dissipation of the LED 200 (See Fig. 1). The reflecting layer 104 is disposed on the heat-conducting layer 102 to reflect the light emitted from the LED 200 to the substrate 100 out. In some embodiments, the material of the heat-conducting layer 102 may be, but is not limited to be, a copper, aluminum, aluminium oxide or aluminium nitride and the like.

In some embodiments, the substrate 100 may optionally include a protecting layer 106 that is disposed on the reflecting layer 104, for protecting the reflecting layer 104. For example, the protecting layer 106 may be, but is not limited to be, a transparent material that can be passed through by light, without influencing the function of the reflecting layer 104.

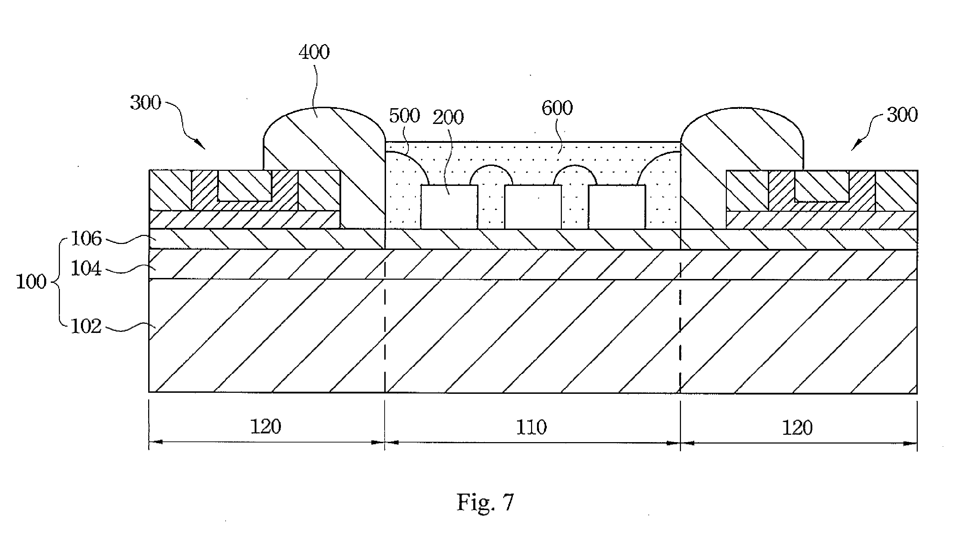

Fig. 7 is a cross-sectional view of a LED package according to another embodiment of the invention. As shown in the figure, this embodiment is substantially similar to the embodiment of Fig. 1, and the main difference is that this embodiment may further include a package 600 disposed on the die-bonding area 110, which covers the LED 200. In particular, the package 600 may be surrounded by the protecting structure 400 and is formed in the die-bonding area 110. In some embodiments, colloid matters or phosphor powders may be doped in the package 600.

In some embodiments, the first dielectric layer 320 may be made of a white dielectric material. For example, the material of the first dielectric layer 320 may be, but is not limited to be, FR-4 epoxy.

## Claims

1. A LED (light emitting diode) package, **characterized by** comprising:
a substrate having a die-bonding area and a wire-bonding area, wherein wire-bonding area surrounds the die-bonding area;
at least one LED disposed in the die-bonding area;
at least one wire-bonding structure disposed in the wire-bonding area, wherein the wire-bonding structure comprises a lateral wall, and the lateral wall stands between the wire-bonding area and the die-bonding area; and
at least one protecting structure covering the lateral wall and part of surface of the wire-bonding structure.

2. The LED package of claim 1, **characterized in that** the wire-bonding structure comprises:
an insulation layer;
a first dielectric layer disposed on the insulation layer; and
a wire layer disposed in a predetermined area of the first dielectric layer.

3. The LED package of claim 2, **characterized in that** the upper surface of the wire layer is partially exposed, so that the exposed upper surface of the wire layer is connected to the LED through a conducting wire.

4. The LED package of claim 3, **characterized in that** part of the first dielectric layer is exposed on the lateral wall of the wire-bonding structure and is covered by the protecting structure.

5. The LED package of claim 4, **characterized in that** the protecting structure at least covers part of the upper surface of the first dielectric layer and part of the exposed wire layer.

6. The LED package of claim 5, **characterized in that** the wire-bonding structure further comprises a second dielectric layer which is disposed on the rest of the upper surface of the first dielectric layer that is not covered by the protecting structure and the exposed wire layer.

7. The LED package of claim 6, **characterized in that** the protecting structure is made of a reflective resin material.

8. The LED package of claim 7, **characterized in that** the reflective resin material is a silicon mixture containing a metal oxide or an epoxy mixture containing a metal oxide.

9. The LED package of any of claims 1-8, **characterized in that** the substrate comprises:
a heat-conducting layer; and
a reflecting layer disposed on the heat-conducting layer.

10. The LED package of claim 9, **characterized in that** the substrate further comprises a protecting layer disposed on the reflecting layer.

11. The LED package of claim 1, **characterized by** further comprising a package disposed in the die-bonding area, which covers the LED.
